# EUROPEAN PATENT SPECIFICATION

(11) **EP 2 391 010 B1**
(45) Date of publication and mention of the grant of the patent: **19.11.2014**
(21) Application number: 11174212.8
(22) Date of filing: 21.05.2008
(51) Int. Cl.: H03K 19/177

(54) **A programmable logic device having complex logic blocks with improved logic cell functionality**
Programmierbare logische Vorrichtung mit komplexen logischen Blöcken mit verbesserter logischer Zellfunktionalität
Dispositif logique programmable disposant de blocs logiques dotés d'une fonctionnalité améliorée de cellule logique

(30) Priority: 21.05.2007 US 751392
(43) Date of publication of application: 30.11.2011
(62) Divisional of application: 08009415.4
(73) Proprietor: Altera Corporation, San Jose, CA 95134 (US)
(72) Inventor: Hutton, Michael D., Mountain View, CA 94040 (US)
(74) Representative: Appelt, Christian W.

(56) References cited:
- EP-A2- 0 569 135
- US-A- 6 154 055
- US-A1- 2005 218 929
- US-A1- 2005 275 427
- US-B1- 7 030 652
- US-B1- 7 167 021
- US-B1- 7 167 022
- US-B2- 6 961 741
- "VIRTEX-5 USER GUIDE", UG190 (V.3.0), XILINX INC., 2 February 2007 (2007-02-02), pages 155-181, XP002493446,

## Description

### BACKGROUND

### 1. Field of the Invention.

The present invention generally relates to Complex Logic Block (CLB) based Programmable Logic Devices (PLDs), and more particularly, CLBs including a plurality of slices, each having one or more logic cells with improved logic, register, arithmetic, logic packing and timing functions and capabilities.

### 2. Description of Related Art

A Programmable Logic Device (PLD) is a semiconductor integrated circuit that contains fixed logic circuitry that can be programmed to perform a host of logic functions. In the semiconductor industry, PLDs are becoming increasingly popular for a number of reasons. Due to the advances of chip manufacturing technology, application specific integrated circuits (ASICs) designs have become incredibly complex. This complexity not only adds to design costs, but also the duration of time needed to develop an application specific design. To compound this problem, product life cycles are shrinking rapidly. As a result, it is often not feasible for original equipment manufacturers (OEMs) to design and use ASICs. OEMs are therefore relying more and more on PLDs. The same advances in fabrication technology have also resulted in PLDs with improved density and speed performance. Sophisticated programming software enables complex logic functions to be rapidly developed for PLDs. Furthermore, logic designs generally can also be easily migrated from one generation of PLDs to the next, further reducing product development times. The closing of the price-performance gap with ASICs and reduced product development times makes the use of PLDs compelling for many OEMs.

The architecture of most PLDs defines a two-dimensional array of logic blocks. Row and column inter-logic block lines, typically of varying length and speed, provide signal and clock interconnects between the blocks of logic in the array. In one type of commercially available PLD, the blocks of logic are referred to as Complex Logic Blocks or CLBs. Each CLB includes a pair of slices. The two slices in each CLB do not have direct connections with one another and are organized in different columns. The slices in each column, however, are connected to the slices of the above and below CLBs, creating independent carry chains. For example, the slices in the first and second columns each receive a carry in (Cin) signal from the previous CLB and generate a carry out signal provided to the next CLB respectively.

Each slice typically includes four logic cells (hereafter simply referred to as "cells"). Each cell includes a 6-input logic function generator, typically referred to as a Look Up Table (LUT), arithmetic circuitry for receiving and generating Cin and Cout carry signals, an output register for generating a registered output, a non-registered output, and storage elements for performing ROM functions. The LUT can be configured as either a single 6-input LUT, or two five input LUTs, both receiving the same set of inputs (e.g., A1-A5).

For more details on CLB based PLDs having slices, see for example the "Virtex-5 User Guide", UG190 (v3.0), February 2, 2007, published by Xilinx Corporation, San Jose, CA, pages 155-181.

US 2005/275427 A1 relates to the general area of the Field Programmable Gate Arrays, and, in particular to the architecture and the structure of the building blocks of the Field Programmable Gate Arrays. The proposed logic units, as separate units or cluster of units, which are mainly comprised of look-up tables, multiplexers, and a latch, implement functions such as addition, subtraction, multiplication, and can perform as shift registers, finite state machines, multiplexers, accumulators, counters, multi-level random logic, and look-up tables, among other functions. Having two outputs, the implementations of the logic unit can operate in split-mode and perform two separate logic and/or arithmetic functions at the same time. Clusters of the proposed logic units, which utilize local interconnections instead of traditional routing channels, add to efficiency, speed, and reduce required real estate.

US 7,167,021 B1 describes a logic device logic module which includes multi-stage combinational logic circuitry (e.g., a four-input look-up table) into which EXCLUSIVE OR ("XOR") circuitry is interposed to give the logic module arithmetic as well as combinational logic capabilities. The XOR circuitry is used to help form an arithmetic sum output signal (as an alternative to a combinational logic output signal) when arithmetic mode operation is desired. The logic module is also augmented with circuitry for providing a carry out signal in arithmetic mode. The logic module can perform such arithmetic operations as one digit or bit of binary addition, subtraction, or multiplication. In all cases a carry in signal is taken into account; and in the case of multiplication, a digit from another partial product or summation of other partial products is also taken into account.

US 7,030,652 B1 describes another logic circuit. The logic circuit comprises a plurality of logic elements. At least one logic element includes, first and second LUT blocks that includes an output; an output multiplexer that includes first and second inputs, an output, and that includes a control output; a control input multiplexer circuit including a control input and including first and second data inputs that can be configured to receive first and second data outputs provided by one or more other logic elements of the plurality of logic elements and that includes a data output that can be connected to the control input of the output multiplexer; and multiple control inputs that can be shared by the first and second LUT blocks.

US 2002/116426 A1 relates to a look-up table apparatus for performing two-bit arithmetic operation including carry generation. The look-up table is modified to perform two concurrent combinatorial functions, or one function for an increased number of inputs. The look-up table of the present invention can implement two full adders or subtractors, or two-bit counters, for example. One portion of the modified look-up table provides two bits of a sum output, and another portion of the modified table provides a fast carry out signal for application to a next stage of an adder/subtractor/counter.

US 7,167,022 B1 disclosed is a logic element that can provide a number of advantageous feature. For example, the logic element can provide efficient and flexible use of LUTs and input sharing. The logic element may also provide for flexible use of one or more dedicated adders and include register functionality.

US 6,154,055 describes a programmable logic array integrated circuit device which includes a plurality of regions of programmable logic disposed on the device in a two-dimensional array of intersecting rows and columns. Interconnection conductors are associated with each row and column. The interconnection conductors associated with each row include some that extend continuously along the entire length of the row and some that extend continuously along only the left or right half of the row. To increase the flexibility with which the logic regions can be connected to the row and column conductors, adjacent regions are paired and circuitry is provided for allowing the outputs of each pair to be swapped for driving the row and column conductors. Registers in logic regions can still be used for other purposes when not being used to register the main combinatorial outputs of the logic regions. Many other enhanced features are also provided.

US 2005/218929 A1 relates to the general area of the Field Programmable Gate Arrays, and, in particular to the architecture and the structure of the building blocks of the Field Programmable Gate Arrays. The proposed logic cells offer, among other advantages, by-pass and feedback paths, fewer transistors, no need for dedicated carry logic or multiple registers, 3-input instead of 4-input look-up tables, easy implementation of up to 4-input logic functions, and multiplication.

EP 0 569 135 A2 provides look up tables for use in programmable logic devices, which are modified to facilitate use of those tables to provide adders (including subtracters) and various types of counters. Each look up table is effectively partitioned into smaller look up tables when an adder or counter is required. One portion of the partitioned table is used to provide a sum out signal, while the other portion of the partitioned table is used to provide a fast carry out signal for application to the next stage of the adder or counter.

The problem with the aforementioned cells is its lack of flexibility and limitations in performing logic, various register, arithmetic functions and a lack of flexibility for efficiently packing logic functions into the cell.

A PLD with CLBs defiling slices having one or more logic cells with improved logic, register, arithmetic, logic packing and timing functions and capabilities is therefore needed.

### SUMMARY OF THE INVENTION

The invention is defined in independent claim 1. Advantageous embodiments are subject to the dependent claims.

A CLB-based PLD with logic cells having improved logic, register, arithmetic, logic packing and timing functions and capabilities is disclosed. The CLBs of the PLD are arranged in rows and columns of an array and are interconnect by a plurality of interconnect lines. Each of the plurality of CLBs has a first slice of logic cells and a second slice of logic cells arranged in a first column and a second column respectively. First and second carry chains are provided between each of the logic cells of each column of slices. At least one of the logic cells includes one or more Look Up Tables for implanting logic functions on a set of inputs provided to the one logic cell and an arithmetic logic circuit configured to receive a carry-in signal and to generate a carry-out signal forming part of the first carry chain. The logic cell further includes an output register an output of which is provided as an input to one of the Look Up Tables of the cell through a register feedback connection. In yet another embodiment, the set of inputs provided to a first and a second of the Look Up Tables are different, enabling a higher degree of logic efficiency or "packing" by enabling each cell to perform logic functions on two different sets of inputs as opposed to only the same set of inputs. Finally, in another embodiment, the arithmetic logic circuit is capable of generating two SUM output signals.

### BRIEF DESCRIPTION OF THE DRAWINGS

The invention may best be understood by reference to the following description taken in conjunction with the accompanying drawings, which illustrate specific embodiments of the present invention.

Figure 1 is a block diagram illustrating a programmable logic device according to the present invention.

Figure 2 is a block diagram of a logic cell used in a CLB based PLD architecture according to the prior art.

Figure 3 is a logic cell with enhanced register functionality being useful in understanding the present invention.

Figure 4 is a logic cell with register feedback according to an embodiment of the present invention.

Figures 5A and 5B are a block diagrams illustrating how register feedback aids in balancing delays between stages of a logic circuit design to reduce the overall propagation delays of the circuit according to the present invention.

Figures 6A-6E are various implementations of the logic cell having improved logic functionality capabilities, and useful for better understanding the invention.

Figure 7 is another embodiment of a logic cell of the present invention having register feedback and an input swap multiplexer.

Figures 8A-8B is a logic cell capable of performing arithmetic on two bits in accordance with another implementation useful for understanding the invention.

It should be noted that like reference numbers refer to like elements in the figures.

### DETAILED DESCRIPTION OF SPECIFIC EMBODIMENTS

The present invention will now be described in detail with reference to a various embodiments thereof as illustrated in the accompanying drawings. In the following description, specific details are set forth in order to provide a thorough understanding of the present invention. It will be apparent, however, to one skilled in the art, that the present invention may be practiced without using some of the implementation details set forth herein. It should also be understood that well known operations have not been described in detail in order to not unnecessarily obscure the present invention. Further, it should be noted that the techniques of the present invention could be applied to a variety of systems or electronic devices such as programmable devices and application-specific integrated circuit (ASIC) devices.

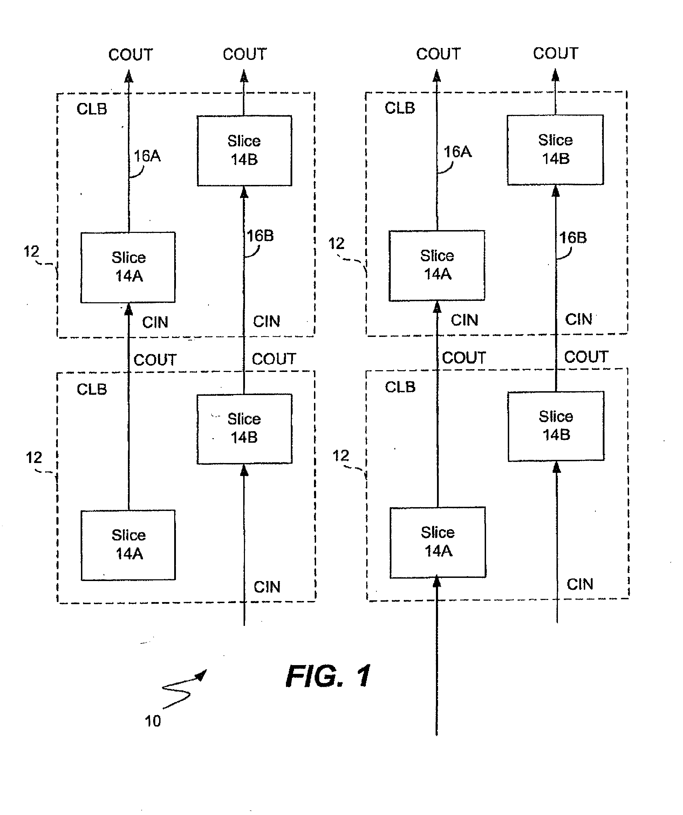

Referring to Figure 1, a block diagram of a programmable logic device (PLD) 10 of the present invention is shown. The PLD includes a plurality of Complex Logic Blocks (CLBs) 12 arranged in an array of rows and columns. Each CLB 12 includes a first slice 14A and a second slice 14B. The slices 14A of the CLBs 12 in a given column are interconnected by a first carry chain 16A, as designated by the carry-in (Cin) and carry-out (Cout) lines received and outputted by the slices 14A. Similarly, the slices 14B are interconnected by a second carry chain 16B, as designated by the carry-in (Cin) and carry-out (Cout) lines received and outputted by the slices 14B. Although not illustrated, the individual CLBs 12 are interconnected by a plurality of inter-CLB lines, as is well known in the art. For more details on CLB based PLDs having slices, see for example the "Virtex-5 User Guide", UG190 (v3.0), February 2, 2007, published by Xilinx Corporation, San Jose, CA.

Each slice 14 includes one or more logic cells. In one specific embodiment, each slice 14 includes four logic cells. In other embodiments, either more or fewer logic cells may be used per slice 14. In alternative embodiments for example, one to three, or five through sixteen or more logic cells may be included per CLB 14. In general, the number of specific logic cells in a CLB is arbitrary, and should not be construed as limiting the present invention.

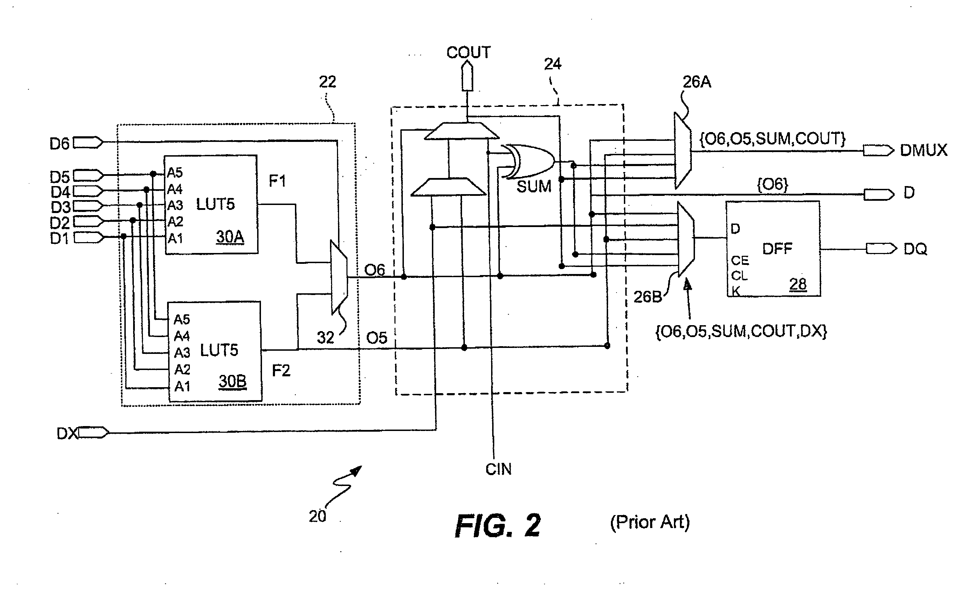

Referring to Figure 2, a block diagram of a logic cell 20 according to the prior art is shown. The logic cell 20 includes a six-input Look Up Table 22, an arithmetic logic circuit 24, two output multiplexers 26A and 26B, and an output register 28.

The six input Look Up Table 22 includes two five-input Look Up Tables 30A and 30B, each configured to receive the same set of inputs D1 through D5, and a Look Up Table output multiplexer 32, which is configured to receive a sixth input D6. With this configuration, the Look Up Table 22 can be configured as either a single six-input Look Up Table capable of generating a single logic function "O6", or two five-input logic functions designated F1(D1, D2, D3, D4, D5) and F2(D1, D2, D3, D4, D5) respectively.

The arithmetic circuit 24 is configured to implement arithmetic logic functions, such as counters and shifter registers. The arithmetic circuit 24 is configured to receive a seventh input (DX) and a carry-in (Cin) from the logic cell below. In response, the arithmetic circuit generates a SUM signal and a carry out signal (Cout), which is provided to the cell above.

The output multiplexer 26A generates a non-registered output (DMUX) selected from inputs (06, O5, SUM and Cout). The output multiplexer 26B selects from inputs (O6, O5, SUM, Cout, and DX). The register 28 generates a registered output (DQ) from the input selected by multiplexer 26B. A third output (D) is derived from the Look Up Table output multiplexer 34 (06).

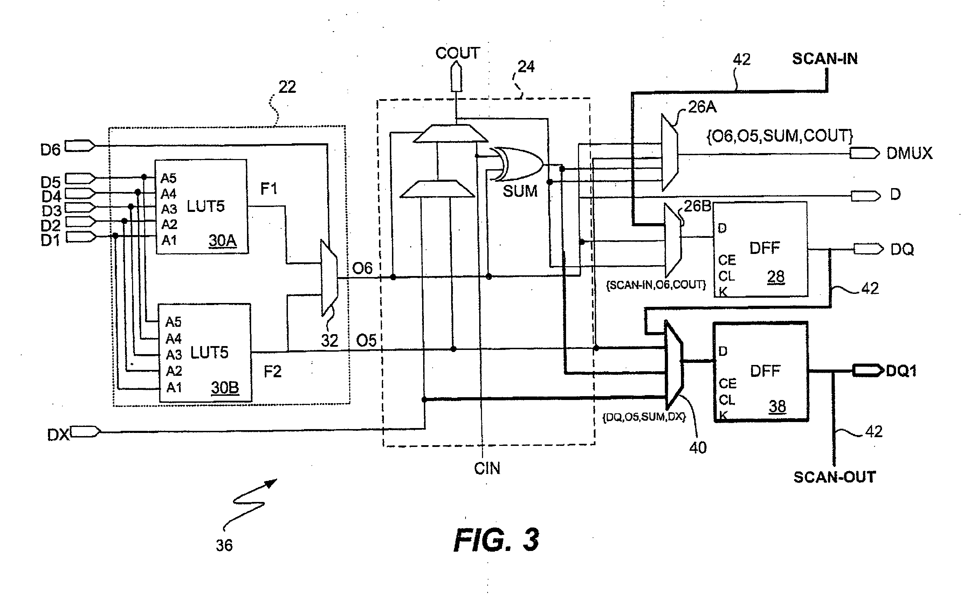

Figure 3 is a logic cell with enhanced register functionality useful for better understanding the present invention. The logic cell 36 is similar to the cell 20, except it additionally includes a second output register 38, output multiplexer 40, and a scan-chain 42. The output multiplexer 26B is configured to receive (scan-in, 06 and Cout), while the multiplexer 40 is configured to receive (DQ, O5, SUM, and DX). The second output register is configured to generate output (DQ1), the value of which is determined by the selection of multiplexer 40.

The scan-chain 42 in Figure 3 allows the output of one register (i.e., 28) to be provided as an input to the next register (i.e., 38). For example in Figure 3, the register 28 receives the "scan-in" signal from the above cell, whereas the register 38 provides the "scan-out" signal to the next cell.

The enhanced register functionality of logic cells 36 provides a number of advantages over conventional cells, such as that illustrated in Figure 2. The scan-chain 42 through the registers 28 and 38 allows greater functionality, such as pipelining and/or the creation of shift registers, between cells. This feature was not possible in the prior cell. The partitioning of the outputs among the two registers 28 and 38 also provides greater flexibility in register packing, which is the ability to efficiently place or "pack" more logic into a given cell.

It should be noted that this specific partitioning of the output signals generated by the logic cell 36 in Figures 3 are merely exemplary. The output signals may be partitioned in any arbitrary way among the output registers. Furthermore, the output signals do not have to be limited to those specifically identified above. Rather, the output signals can be selected from generic signals, such as outputs of the Look Up Tables of the cell, a sum, carry-out signal, or any other signal generated by the arithmetic circuit 24, or any of the inputs to the logic cell.

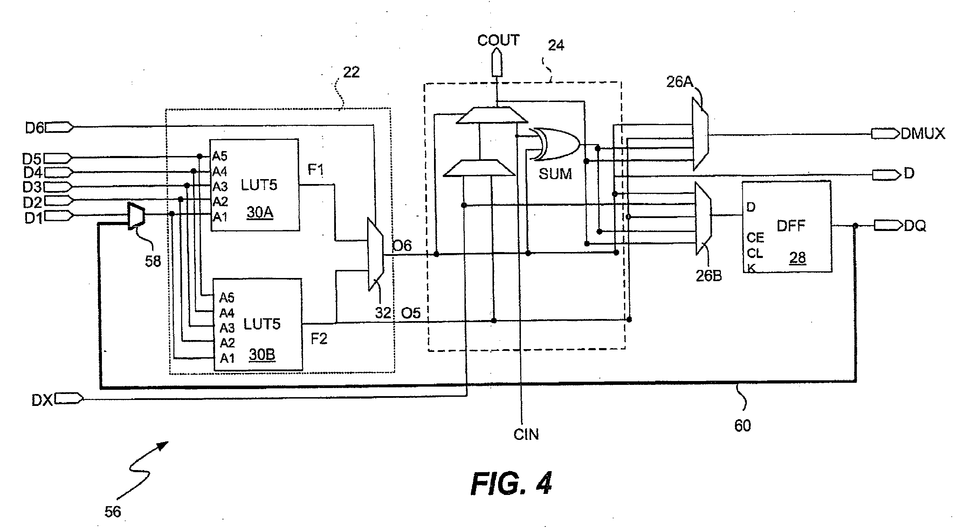

Referring to Figure 4, a logic cell 56 with register feedback according to another embodiment of the present invention is shown. The logic cell 56 is similar to that of Figure 2, except it includes a multiplexer 58 and a feedback path 60 between the (DQ) output of the register 28 and the multiplexer 58. In the embodiment shown, the multiplexer 58 receives two inputs, D1 and DQ. Accordingly, the registered output of the cell 56 can be selectively provided as an input to both five-input Look Up Tables 30A and 30B. Although the multiplexer 58 is shown coupled to the input D1, it should be noted that the multiplexer 58 can be used to "swap" the registered output (DQ) for any of the logic cell inputs D1 through D6.

Pipelining is common in circuit design technique. With pipelining, a complex circuit is broken down or partitioned into a plurality of clocked pipelined stages. At each stage, the circuit performs a specific operation. With each clock cycle, the results of each stage are transitioned to the next stage. The speed (i.e., frequency) or clock cycle of the pipelined circuit is dictated by the longest propagation path between any two stages in the pipeline. For example, if a number of stages have a propagation delay of 5 nanoseconds, but one stage has a delay of 10 nanoseconds, then the entire circuit must operate at the 10 nanosecond rate. Higher speed performance can therefore be achieved if a better balance of the delays at the various stages of the circuit can be achieved.

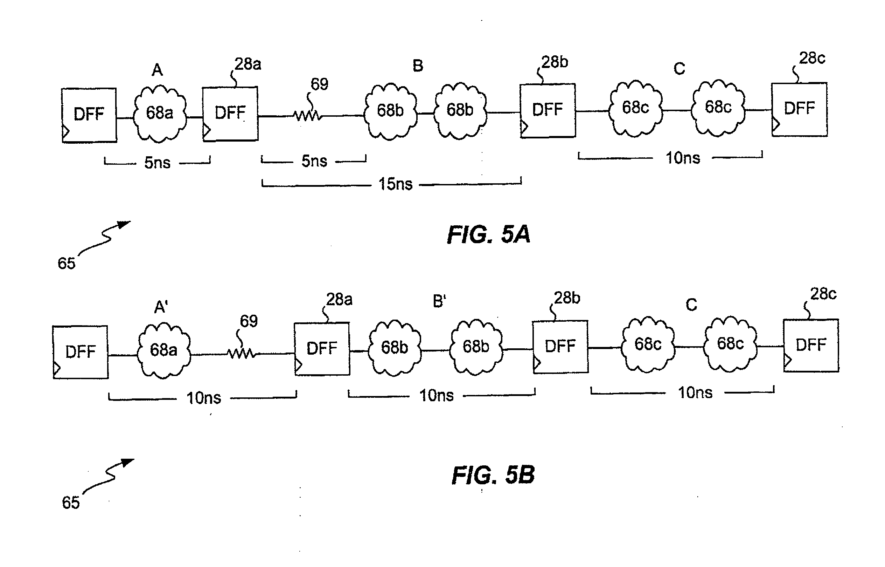

Referring to Figure 5A, a block diagram 65 illustrating how register feedback aids in balancing delays between pipelined stages of a logic circuit according to the present invention is shown. In the diagram, three stages A, B and C are provided. The first stage A has a circuit 68 with a 5 nanosecond delay followed by register 28a. The second stage B has a long wire 69 with a 5 nanosecond delay, a first circuit 68b with a 5 nanosecond delay and a second circuit 68b with another 5 nanosecond delay, followed by a register 28b. The third stage C has two circuits 68c with a combined 10 nanosecond delay and a register 28c. By using the register feedback 60 as illustrated in Figure 4, the delay of the long wire 69 can be made to occur before (i.e., to the left of) the register 28a, rather than after (i.e., or to the right of the register). This shifting of the delay associated with wire 69 is logically illustrated in Figure 5B. As a result, the delay at each of the three stages has been balanced with each being 10 nanoseconds. Consequently, as illustrated in this example, the register feedback 60 can be used to improve the clock speed or frequency at which the logic circuit operates, thereby improving performance.

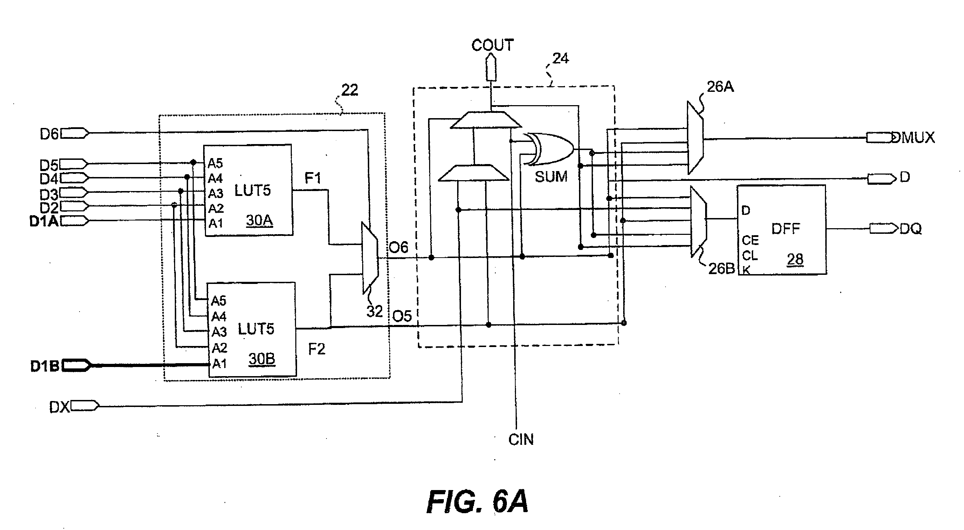

Figures 6A-6E show various implementations of a logic cell having improved logic functionality capabilities. As noted above, the two Look Up Tables in the cell 20 of Figure 2 have limited flexibility, as each is limited in receiving the same inputs (D1, D2, D3, D4, D5). Figures 6A - 6E in contrast show various implementations where different combinations of inputs can be provided to the two five-input Look Up Tables 30A and 30B respectively. This flexibility aid in improving the density or "packing" as more logic can be squeezed into two Look Up Tables 30A and 30B capable of operating on different inputs, as opposed to operating only on the same set of inputs.

In Figure 6A, the Look Up Table 30A receives inputs (D1A, D2, D3, D4, D5) and generates function F1 (D1A, D2, D3, D4, D5). Look Up Table 30B receives (D1B, D2, D3, D4, D5) and generates function F2 (D1B, D2, D3, D4, D5). The D1 input to the two Look Up Tables 30A and 30B is therefore different This arrangement improves flexibility when the two Look Up Tables 30A and 30B are used in a fractured mode. For example, since 30A and 30B are sharing only four inputs, they can be configured as two independent three-input Look Up Tables, or two four-input Look Up Tables, with only two common inputs. It should be noted that the use of different inputs for D1 is only exemplary. Any of the inputs D1 through D5 can be different in accordance with this implementation.

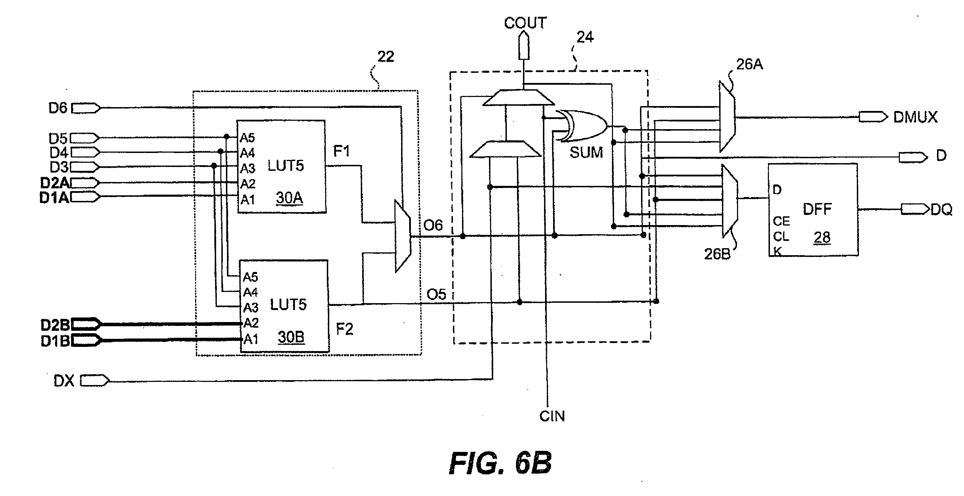

In Figure 6B, the Look Up Table 30A receives inputs (D1A, D2A, D3, D4, D5) and generates function F1 (D1A, D2A, D3, D4, D5). Look Up Table 30B receives (D1B, D2B, D3, D4, D5) and generates function F2 (D1B, D2B, D3, D4, D5). The D1 and D2 inputs to the two Look Up Tables 30A and 30B is therefore different. This arrangement also improves flexibility when the two Look Up Tables 30A and 30B are used in a fractured mode. For example, since 30A and 30B can each implement four-input Look Up Tables with two common inputs. It should be noted that the use of different inputs for D1 and D2 is only exemplary. Any two of the inputs D1 through D5 can be different in accordance with this implementation.

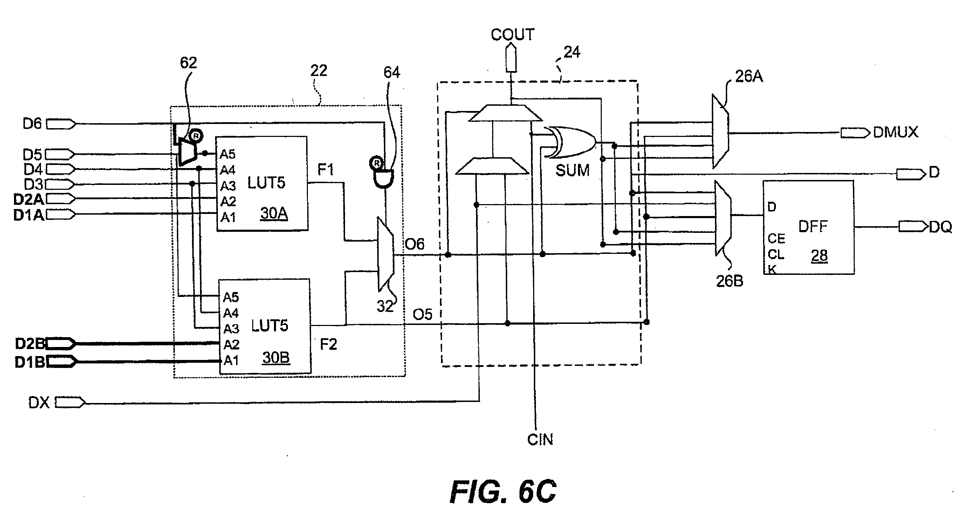

Figure 6C is similar to Figure 6B with the Look Up Table 30A receiving inputs (D1A, D2A, D3, D4, D5) and Look Up Table 30B receiving inputs (D1B, D2B, D3, D4, D5). In addition, a swap multiplexer 62, AND gate 64 and a programming bit "R" are provided to control the multiplexer 62 and gate 64. The swap multiplexer 62 allows either the input D5 or D6 to be provided to the fifth input of Look Up Table 30A. When the value of the programming bit R is set so that the input D6 is selected by the multiplexer 62, the output of the AND gate 64 will force the multiplexer 32 to select the function F1 from the Look Up Table 30A. Thus, if D6 is used as an input, the Look Up Table 30A will always be selected by multiplexer 32. With the R bit set, Look Up Table 30A generates the function F1 (D6, D3, D2A, D1A) and 30B generates the function F2 (D5, D4, D2B, D1B). When the R bit is reset, then the 30A and 30B implement two five-input Look Up Tables with two common inputs respectively.

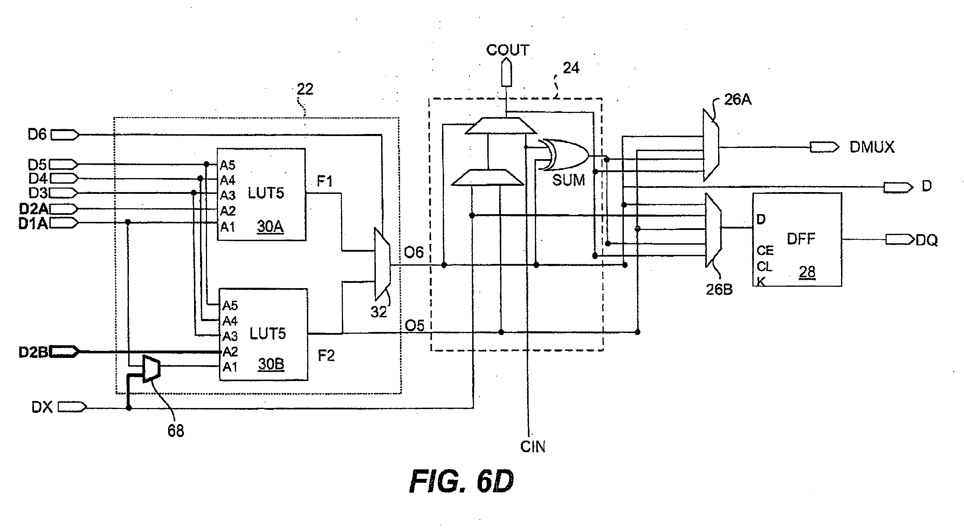

Figure 6D is similar to Figure 6B, except it includes a swap multiplexer 68 coupled to receive the DX or D1A inputs. With this arrangement, the Look Up Table 30B receives either DX or D1A, instead of D1B as illustrated in Figure 6B. By providing the swap multiplexer 68, it allows the DX input to be substituted for the otherwise shared input D1, allowing the 30A and 30B to be fractured into two four-input Look Up Tables. F1 is therefore (D5, D3, D2A, D1A) and F2 is (D5, D4, D2B, DX).

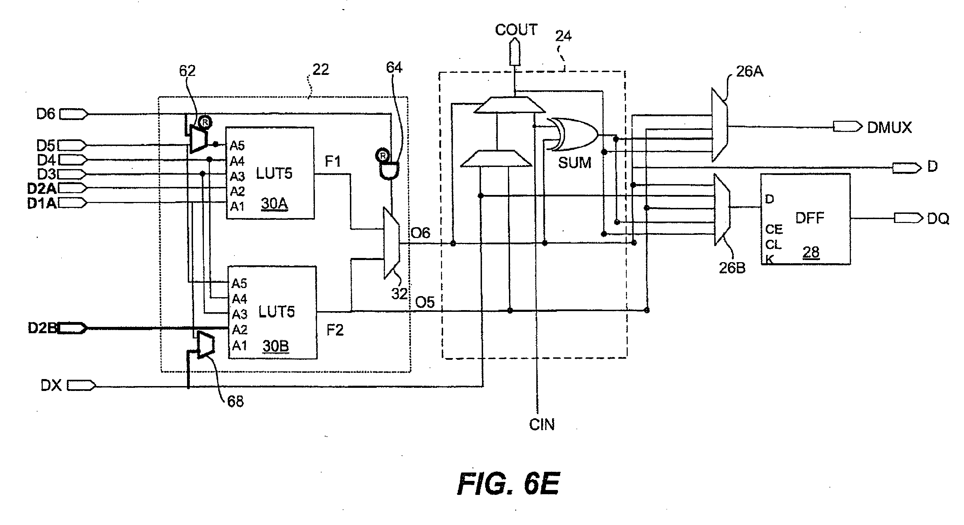

Figure 6E is the combination of Figures 6C and 6D. With this arrangement, 30A and 30B can be configured as two five-input Look Up Tables with common inputs, or two fractured Look Up Tables generating F1(D6, D4, D3, D2A, D1A) and F2(D5, D3, D4, D2B, DX) respectively.

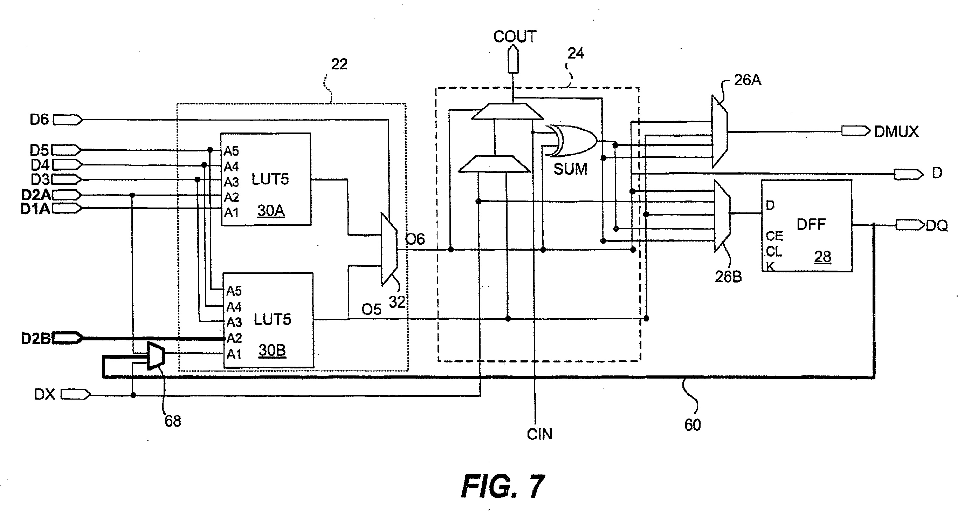

Figure 7 is another embodiment of a logic cell of the present invention having register feedback and an input swap multiplexer. This embodiment is essentially the combination Figures 5A including register feedback 60 and the swap multiplexer 68 of Figure 6D. In this case, the swap multiplexer receives three inputs, including D2A, DX and the register feedback 60. With this arrangement, 30A and 30B are capable of generating two 5-LUT functions, the lower of which is able to use the feedback register driven by DX as one of it's inputs.

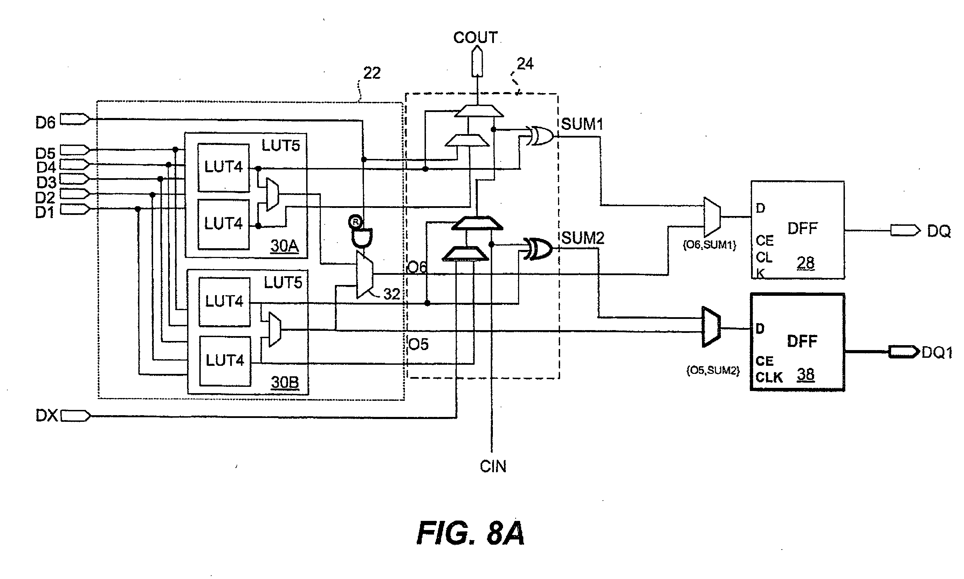

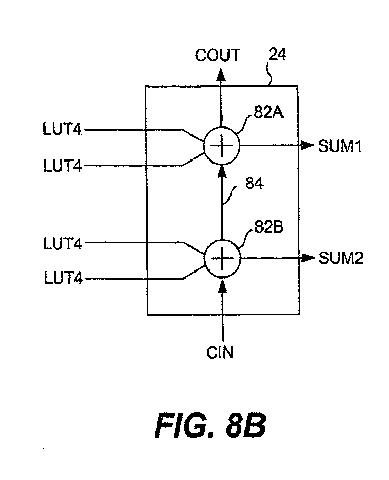

Figure 8A is a cell having an arithmetic logic circuit 24 capable of generating two sum outputs, SUM1 and SUM2. The first SUM1 signal is derived by the addition from two signals from the first Look Up Table 30A, whereas the second SUM2 is generated from two signals from the second Look Up Table 30B. As is well understood in the art, a five-input Look Up Table is essentially two four-input multiplexers and a select multiplexer that is controlled by the fifth input. For this reason, the diagram of Figure 8 shows two four-input Look Up Tables and a multiplexer for elements 30A and 30B respectively. For the sake of simplicity, the non-registered output and output multiplexer of the cell are not shown.

Figure 8B is a logic diagram illustrating the arithmetic logic circuit 24 of Figure 8A. As illustrated, the SUM1 signal is generated by a first adder 82A from the sum of two four-input Look Up Tables, and the signal SUM2 is generated by a second adder 82b from the sum of a second two four-input Look Up Tables. A carry signal 84 is provided between the two adders 84B and 84A.

According to an aspect of the invention, an apparatus is provided which comprises a programmable logic device. The programmable logic device includes a plurality of CLBs arranged in rows and columns of an array and a plurality of inter-CLB lines interconnecting the CLBs of the array. Each of the plurality of CLBs has a first slice of logic cells and a second-slice of logic cells, wherein the first slice of logic cells and the second slice of logic cells of the CLBs in a given column of the array are interconnected by a first carry chain and a second carry chain respectively. One of the logic cells includes one or more Look Up Tables for implanting logic functions on a set of inputs provided to the one logic cell; an arithmetic logic circuit configured to receive a carry-in signal and to generate a carry-out signal forming part of the first carry chain; a first output register configured to generate a registered output; and an input multiplexer configured to select either one of the set of inputs provided to the logic cell or the registered output to the one or more Look Up Tables in the one logic cell.

This apparatus further comprises a register feedback path coupled between the registered output of the first register and the input multiplexer.

The apparatus further comprises a second of the logic cells having one or more Look Up Tables, the one or more Look Up Tables of the second of the logic cells being configured to programmably receive the registered output of the first register of the one logic cell through the register feedback path.

One of the logic cells includes a first Look Up Table for implanting logic functions on a first set of inputs provided to the one logic cell; and a second Look Up Table for implementing logic functions on a second set of inputs provided to the one logic cell, wherein the first set of inputs and the second set of inputs contain similar inputs, but at least one of the inputs in the first set and the second set are different

In one exemplary first sub-aspect, the first set of inputs comprises (D1A, D2, D3, D4 and D5) and the first Look Up Table may generate a logic function F1 (D1A, D2, D3, D4 and D5) and the second set of inputs may comprise (D1B, D2, D3, D4 and D5) and the second Look Up Table may generate a logic function F2 (D1B, D2, D3, D4 and D5) respectively.

In another exemplary second sub-aspect, the first set of inputs comprises (D1A, D2A, D3, D4 and D5) and the first Look Up Table generates a logic function F1 (D1A, D2A, D3, D4 and D5) and the second set of inputs comprises (D1B, D2B, D3, D4 and D5) and the second Look Up Table generates a logic function F2 (D1B, D2B, D3, D4 and D5) respectively.

In another exemplary third sub-aspect, the first Look Up Table is a five-input Look Up Table and the second Look Up Table is also a five-input Look Up Table, the one logic cell further comprising a Look Up Table output multiplexer configured to receive the outputs of the first and the second Look Up Tables and a sixth input for controlling the output of the Look Up Table output multiplexer.

In an exemplary implementation of the third sub-aspect, the apparatus further comprises a programmable select multiplexer coupled to a selected one of the first set of inputs and the sixth input, the select multiplexer being configured to programmably select either the select one of the first set of inputs or the sixth input as an input to the first Look Up Table.

Moreover, in an even more detailed implementation of the third sub-aspect, the apparatus further may comprise a configurable bit used to control the programmable select multiplexer and the Look Up Table multiplexer so that when the sixth input is selected as an input to the first Look Up Table, the Look Up Table output multiplexer is configured to select the second Look Up Table.

In another exemplary implementation of the third sub-aspect, the apparatus further comprises a seventh input to the one logic cell and a select multiplexer configured to selectively provide either the seventh input or one of the second set of inputs to the second Look Up Table.

In a further exemplary implementation of the third sub-aspect, the apparatus further comprises a register feedback signal from a register of the one logic cell and a select multiplexer configured to selectively provide either the register feedback signal or one of the second set of inputs to the second Look Up Table.

According to an exemplary sub-aspect, the one logic cell further comprises a first output register to receive the first SUM signal and a second output register to receive the second SUM signal.

In an exemplary more detailed implementation of this sub-aspect, the arithmetic logic circuit generates the first SUM signal by adding a first two signals from a first Look Up Table and the second SUM signal by adding a second two signals from a second Look Up Table respectively.

## Claims

1. An apparatus comprising:
a programmable logic device (10) including:
a plurality of Complex Logic Blocks, CLBs (12), arranged in rows and columns of an array;
a plurality of inter-CLB lines interconnecting the plurality of CLBs of the array; and
each of the plurality of CLBs having a first slice (14A) and a second slice (14B), wherein the first slice and the second slice of the plurality of CLBs in a given column of the array are interconnected by a first carry chain (16A) and a second carry chain (16B) respectively, and wherein the first slice and the second slice each contain one or more logic cells; and
one of the logic cells of the first slice or second slice including:
- one or more Look Up Tables (30A, 30B) for implementing logic functions on a set of inputs provided to the one of the logic cells;
- an arithmetic logic circuit (24) configured to receive a carry-in signal and to generate a carry-out signal forming part of the first carry chain;
- a first output multiplexer (26A);
- a second output multiplexer (26B);
**characterized in that**
- an output register (28) is connected to the second output multiplexer (26B) for generating a registered output (DQ) from an input selected by the second output multiplexer (26B);
- an input multiplexer (58) is provided;
- a register feedback path (60) being coupled between the registered output of the output register (28) and the input multiplexer (58);
- the output register (28) of the one of the logic cells is adapted to provide its registered output (DQ) as a feedback signal from the output register (28) to the input multiplexer (58), and
- the input multiplexer (58) of the one of the logic cells is configured to provide either one of the set of inputs provided to the one of the logic cells, or the registered feedback signal, to the one or more Look Up Tables (30A, 30B) in the one of the logic cells; and
- another, second of the logic cells having one or more Look Up Tables, the one or more Look Up Tables of the second of the logic cells being configured to programmably receive the registered output of the output register (28) through the register feedback path (60).

2. The apparatus of claim 1, wherein said one or more Look Up Tables (30A, 30B) are a first Look Up Tabe (30A) and a second Look Up Table (30B) and the input multiplexer (58) is configured to provide either one of the set of inputs provided to the one of the logic cells or the registered feedback signal to only the second Look Up Table.

3. The apparatus of claim 2, wherein the first Look Up Table is a five-input Look Up Table, wherein the second Look Up Table is a five-input Look Up Table, wherein the set of inputs includes a first set of inputs and a second set of inputs, wherein the first Look Up Table is configured to implement logic functions on the first set of inputs, wherein the second Look Up Table is configured to implement logic functions on the second set of inputs, wherein at least one input (D2A) of the first set is different than at least one input (D2B) of the second set.

4. The apparatus of claim 3, wherein the one of the logic cells comprises a Look Up Table output multiplexer (32) configured to receive outputs of the first and second Look Up Tables, wherein the Look Up Table output multiplexer is configured to be controlled by a sixth input (D6), wherein the arithmetic logic circuit is configured to receive a seventh input (DX) and the carry-in signal to generate a SUM signal and the carry-out signal, wherein the one of the logic cells further comprises a swap multiplexer (68), being configured to select from the at least one input (D2A) of the first set, the registered output, and the seventh input.

5. The apparatus of claim 1, wherein the first slices in a column of the array are interconnected by the first carry chain, and wherein the second slices in a column of the array are interconnected by the second carry chain.

6. The apparatus of claim 1, wherein the first Look Up Table is configured to implement logic functions on a first set of inputs received by the first Look Up Table, wherein the second Look Up Table is configured to implement logic functions on a second set of inputs received by the second Look Up Table, where inputs of the first set are same as inputs of the second set.

7. The apparatus of claim 5, wherein the arithmetic logic circuit outputs a SUM signal, wherein the one of the logic cells comprises a Look Up Table output multiplexer (32), wherein the Look Up Table output multiplexer is configured to receive outputs of the first and second Look Up Tables, wherein the Look Up Table output multiplexer is configured to be controlled by a sixth input (D6) to generate a first logic function (06), wherein the second Look Up Table is configured to generate a second logic function (05), wherein the one of the logic cells includes the first output multiplexer (26A) configured to select from the SUM signal, the carry-out signal, the first logic function, and the second logic function.

8. The apparatus of claim 7 further comprising the second output multiplexer (26B) configured to select from the SUM signal, the carry-out signal, the first logic function, the second logic function, and a seventh input (DX), wherein the arithmetic logic circuit is configured to receive the seventh input.

## Patentansprüche

1. Vorrichtung, die Folgendes umfasst:
eine programmierbare Logikeinrichtung (10), die Folgendes enthält:
mehrere CLBs (Complex Logic Blocks, CLB) (12), die in Zeilen und Spalten eines Arrays angeordnet sind;
mehrere Inter-CLB-Leitungen, die die mehreren CLBs des Arrays zusammenschalten; und
wobei jeder der mehreren CLBs eine erste Slice (14A) und eine zweite Slice (14B) aufweist, wobei die erste Slice und die zweite Slice der mehreren CLBs in einer gegebenen Spalte des Arrays durch eine erste Carry-Chain (16A) bzw. eine zweite Carry-Chain (16B) zusammengeschaltet sind und wobei die erste Slice und die zweite Slice jeweils eine oder mehrere Logikzellen enthalten; und
eine der Logikzellen der ersten oder zweiten Slice Folgendes enthält:
- eine oder mehrere LUTs ("Look Up Tables") (30A, 30B) zum Implementieren von Logikfunktionen an einem Satz von Eingaben, die an die eine der Logikzellen geliefert werden;
- eine arithmetische Logikschaltung (24), die zum Empfangen eines Carry-In-Signals und zum Generieren eines Carry-Out-Signals konfiguriert ist, die Teil der ersten Carry-Chain sind;
- einen ersten Ausgangsmultiplexer (26A);
- einen zweiten Ausgangsmultiplexer (26B);
**dadurch gekennzeichnet, dass**
- ein Ausgangsregister (28), mit dem zweiten Ausgangsmultiplexer (26B) verbunden ist, um eine registrierte Ausgabe (DQ) von einem durch den zweiten Ausgangsmultiplexer (26B) gewählten Ausgang zu generieren;
- ein Eingangsmultiplexer (58) bereitgestellt wird;
- ein Registerrückkoppelpfad (60) zwischen den registrierten Ausgang des Ausgangsregisters (28) und den Eingangsmultiplexer (58) gekoppelt ist;
- das Ausgangsregister (28) der einen der Logikzellen ausgelegt ist, ihre registrierte Ausgabe (DQ) als ein Rückkoppelsignal vom Ausgangsregister (28) an den Eingangsmultiplexer (58) zu liefern, und
- der Eingangsmultiplexer (58) der einen der Logikzellen konfiguriert ist, entweder eine Eingabe des Satzes von an die eine der Logikzellen gelieferten Eingaben oder das registrierte Rückkopplungssignal an die eine oder mehreren LUTs (30A, 30B) in der einen der Logikzellen zu liefern; und
- eine andere, zweite, der Logikzellen eine oder mehrere LUTs aufweist, wobei die eine oder mehreren LUTs der zweiten der Logikzellen konfiguriert sind, die registrierte Ausgabe des Ausgangsregisters (28) durch den Registerrückkoppelpfad (60) programmierbar zu empfangen.

2. Vorrichtung nach Anspruch 1, wobei die eine oder mehreren LUTs (30A, 30B) eine erste LUT (30A) und eine zweite LUT (30B) sind und der Eingangsmultiplexer (58) konfiguriert ist, entweder eine Eingabe des Satzes von an die eine der Logikzellen gelieferten Eingaben oder das registrierte Rückkopplungssignal nur an die zweite LUT zu liefern.

3. Vorrichtung nach Anspruch 2, wobei die erste LUT eine LUT mit fünf Eingängen ist, wobei die zweite LUT eine LUT mit fünf Eingängen ist, wobei der Satz von Eingaben einen ersten Satz von Eingaben und einen zweiten Satz von Eingaben enthält, wobei die erste LUT konfiguriert ist, Logikfunktionen an dem ersten Satz von Eingaben zu implementieren, wobei die zweite LUT konfiguriert ist, Logikfunktionen an dem zweiten Satz von Eingaben zu implementieren, wobei mindestens eine Eingabe (D2A) des ersten Satzes von mindestens einer Eingabe (D2B) des zweiten Satzes verschieden ist.

4. Vorrichtung nach Anspruch 3, wobei die eine der Logikzellen einen LUT-Ausgangsmultiplexer (32) umfasst, der konfiguriert ist, Ausgaben der ersten und zweite LUTs zu empfangen, wobei der LUT-Ausgangsmultiplexer konfiguriert ist, von einem sechsten Eingang (D6) gesteuert zu werden, wobei die arithmetische Logikschaltung konfiguriert ist, einen siebten Eingang (DX) und das Carry-In-Signal zu empfangen, um das SUM-Signal und das Carry-Out-Signal zu generieren, wobei die eine der Logikzellen weiterhin einen Swap-Multiplexer (68) umfasst, der konfiguriert ist, unter der mindestens eine Eingabe (D2A) des ersten Satzes, dem registrierten Ausgang und dem siebten Eingang zu wählen.

5. Vorrichtung nach Anspruch 1, wobei die ersten Slices in einer Spalte des Arrays durch die erste Carry-Chain zusammengeschaltet sind und wobei die zweiten Slices in einer Spalte des Arrays durch die zweite Carry-Chain zusammengeschaltet sind.

6. Vorrichtung nach Anspruch 1, wobei die erste LUT konfiguriert ist, Logikfunktionen an einem ersten Satz von Eingängen, von der ersten LUT erhalten, zu implementieren, wobei die zweite LUT konfiguriert ist, Logikfunktionen an einem zweiten Satz von Eingaben, von der zweiten LUT erhalten, zu implementieren, wobei Eingaben des ersten Satzes die gleichen sind wie Eingaben des zweiten Satzes.

7. Vorrichtung nach Anspruch 5, wobei die arithmetische Logikschaltung ein SUM-Signal ausgibt, wobei die eine der Logikzellen einen LUT-Ausgangsmultiplexer (32) umfasst, wobei der LUT-Ausgangsmultiplexer konfiguriert ist, Ausgaben der ersten und zweite LUT zu empfangen, wobei der LUT-Ausgangsmultiplexer konfiguriert ist, von einem sechsten Eingang (D6) gesteuert zu werden, um eine erste Logikfunktion (06) zu generieren, wobei die zweite LUT konfiguriert ist, eine zweite Logikfunktion (05) zu generieren, wobei die eine der Logikzellen den ersten Ausgangsmultiplexer (26A) enthält, der konfiguriert ist, unter dem SUM-Signal, dem Carry-Out-Signal, der ersten Logikfunktion und der zweiten Logikfunktion zu wählen.

8. Vorrichtung nach Anspruch 7, weiterhin umfassend den zweiten Ausgangsmultiplexer (26B), der konfiguriert ist, unter dem SUM-Signal, dem Catry-Out-Signal, der ersten Logikfunktion, der zweiten Logikfunktion und einem siebten Ausgang (DX) zu wählen, wobei die arithmetische Logikschaltung konfiguriert ist, den siebten Eingang zu empfangen.

## Revendications

1. Appareil comportant:
un dispositif logique programmable (10) qui comprend:
une pluralité de blocs logiques complexes, BLC (12) disposés en rangées et en colonnes dans un tableau;
une pluralité de lignes entre les BLC servant à connecter entre eux la pluralité de BLC du tableau; et
chacun parmi la pluralité de BLC comporte un premier groupe (14A) et un deuxième groupe (14B), **caractérisé en ce que** le premier groupe et le deuxième groupe parmi la pluralité de BLC dans une colonne donnée du tableau sont interconnectés respectivement par une première chaîne de retenue (16A) et une deuxième chaîne de retenue (16B), et **caractérisé en ce que** le premier groupe et le deuxième groupe contiennent chacun une ou plusieurs cellules logiques, et
l'une des cellules logiques du premier groupe ou du deuxième groupe comprend:
- une ou plusieurs tables de correspondance (30A, 30B) servant à mettre en oeuvre les fonctions logiques sur un ensemble d'entrées menées à l'une des cellules logiques;
- un circuit logique arithmétique (24) configuré de manière à recevoir un signal reporté et à produire un signal de retenue faisant partie de la première chaîne de retenue;
- un premier multiplexeur de sortie (26A);
- un deuxième multiplexeur de sortie (26B);
**caractérisé en ce que**
- un registre de sortie (28) est connecté au deuxième multiplexeur de sortie (26B) en vue de produire une sortie enregistrée (DQ) à partir d'une entrée sélectionnée par le deuxième multiplexeur de sortie (26B);
- un multiplexeur d'entrée (58) est prévu;
- une voie de retour du registre (60) est connectée entre la sortie enregistrée du registre de sortie (28) et le multiplexeur d'entrée (58);
- le registre de sortie (28) de l'une des cellules logiques est adapté de manière à ce que sa sortie enregistrée (DQ) serve de signal de retour entre le registre de sortie (28) et le multiplexeur d'entrée (58), et
- le multiplexeur d'entrée (58) de l'une des cellules logiques est configuré de manière à envoyer l'un des ensembles d'entrées prévus vers l'une des cellules logiques, ou bien le signal de retour enregistré, vers l'une ou plusieurs des tables de correspondance (30A, 30B) dans l'une des cellules logiques; et
- une deuxième cellule parmi les cellules logiques possède une ou plusieurs tables de correspondance, ces tables de correspondance de la deuxième cellule parmi les cellules logiques étant configurées de manière à recevoir, de façon programmable, la sortie enregistrée du registre de sortie (28) par la voie de retour du registre (60).

2. Appareil selon la revendication 1, **caractérisé en ce que** le ou les tables de correspondance (30A, 30B) comprennent une première table de correspondance (30A) et une deuxième table de correspondance (30B), et **en ce que** le multiplexeur d'entrée (58) est configuré de manière à envoyer l'un des ensembles d'entrées prévus vers l'une des cellules logiques, ou bien le signal de retour enregistré vers la seule deuxième table de correspondance.

3. Appareil selon la revendication 2, **caractérisé en ce que** la première table de correspondance est une table de correspondance à cinq entrées, **en ce que** la deuxième table de correspondance est une table de correspondance à cinq entrées, **en ce que** l'ensemble d'entrées comprend un premier ensemble d'entrées et un deuxième ensemble d'entrées, **en ce que** la première table de correspondance est configurée de manière à appliquer des fonctions logiques sur le premier ensemble d'entrées, **en ce que** la deuxième table de correspondance est configurée de manière à appliquer des fonctions logiques sur le deuxième ensemble d'entrées, et **en ce qu'**au moins l'une des entrées (D2A) du premier ensemble est différente par rapport au moins à l'une des entrées (D2B) du deuxième ensemble.

4. Appareil selon la revendication 3, **caractérisé en ce que** l'une des cellules logiques comprend un multiplexeur de sortie (32) pour la table de correspondance qui est configuré de manière à recevoir les sorties des première et deuxième tables de correspondance, **caractérisé en ce que** le multiplexeur de sortie pour la table de correspondance est configuré de manière à être contrôlé par une sixième entrée (D6), **caractérisé en ce que** le circuit logique arithmétique est configuré de manière à recevoir une septième entrée (DX) et **en ce que** le signal reporté est configuré de manière à produre un signal SOMME ainsi que le signal de retenue, **caractérisé en ce que** l'une des cellules logiques comporte par ailleurs un multiplexeur d'échange (68) qui est configuré de manière à sélectionner parmi au moins l'une des entrées (D2A) du premier ensemble, la sortie enregistrée, et la septième entrée.

5. Appareil selon la revendication 1, **caractérisé en ce que** les premiers groupes dans une colonne du tableau sont interconnectés par la première chaîne de retenue, et **en ce que** les deuxièmes groupes dans une colonne du tableau sont interconnectés par la deuxième chaîne de retenue.

6. Appareil selon la revendication 1, **caractérisé en ce que** la première table de correspondance est configurée de manière à appliquer des fonctions logiques sur un premier ensemble d'entrées reçues par la première table de correspondance, **caractérisé en ce que** la deuxième table de correspondance est configurée de manière à appliquer des fonctions logiques sur un deuxième ensemble d'entrées reçues par la deuxième table de correspondance, les entrées du premier ensemble étant les mêmes que les entrées du deuxième ensemble.

7. Appareil selon la revendication 5, **caractérisé en ce que** le circuit logique arithmétique produit à la sortie un signal SOMME, **caractérisé en ce que** l'une des cellules logiques comprend un multiplexeur de sortie (32) pour la table de correspondance, **en ce que** le multiplexeur de sortie pour la table de correspondance est configuré de manière à recevoir les sorties des première et deuxième tables de correspondance, **en ce que** le multiplexeur de sortie pour la table de correspondance est configuré de manière à être contrôlé par une sixième entrée (D6) afin de produire une première fonction logique (06), **caractérisé en ce que** la deuxième table de correspondance est configurée de manière à produire une deuxième fonction logique (05), et **caractérisé en ce que** l'une des cellules logiques comprend le premier multiplexeur de sortie (26A) qui est configuré de manière à sélectionner parmi le signal SOMME, le signal de retenue, la première fonction logique, et la deuxième fonction logique.

8. Appareil selon la revendication 7, comportant par ailleurs le deuxième multiplexeur de sortie (26B) qui est configuré de manière à sélectionner parmi le signal SOMME, le signal de retenue, la première fonction logique, la deuxième fonction logique, et une septième entrée (DX), **caractérisé en ce que** le circuit logique arithmétique est configuré de manière à recevoir la septième entrée.
